# EUROPEAN PATENT SPECIFICATION

(11) **EP 3 162 487 B1**
(45) Date of publication and mention of the grant of the patent: **07.08.2019**
(21) Application number: 15811001.5
(22) Date of filing: 26.06.2015
(51) Int. Cl.: C01B 33/035, C30B 33/06, B23K 20/06, B23K 20/26, B23K 101/00, B23K 103/08

(54) **POLYSILICON FILAMENT BINDING DEVICE USING POLYSILICON FRAGMENTS**
POLYSILICIUMFILAMENTBINDENDE VORRICHTUNG UNTER VERWENDUNG VON POLYSILICIUMFRAGMENTEN
DISPOSITIF DE LIAISON DE FILAMENT DE POLYSILICIUM À PARTIR DE FRAGMENTS DE POLYSILICIUM

(30) Priority: 27.06.2014 KR 20140079452
(43) Date of publication of application: 03.05.2017
(73) Proprietor: OCI Company Ltd., Seoul 100-718 (KR)
(72) Inventor: KANG, Byung-Chang, Seongnam-si Gyeonggi-do 462-807 (KR); KIM, Chang-Ryol, Seongnam-si Gyeonggi-do 462-807 (KR)
(74) Representative: AWA Sweden AB
(86) International application number: PCT/KR2015/006587
(87) International publication number: WO 2015/199498

(56) References cited:
- EP-A1- 2 431 329
- JP-A- H 054 877
- JP-A- S62 207 574
- JP-A- S63 242 339
- JP-A- 2002 254 179
- KR-A- 20030 061 747
- KR-A- 20140 071 279
- US-A1- 2011 220 283

## Description

### [Technical Field]

The present disclosure relates to a polysilicon filament bonding device, and more particularly, to a polysilicon filament bonding device for manufacturing a polysilicon filament with a desired length by bonding polysilicon fragments separated due to damage or the like.

### [Background Art]

When polysilicon is prepared using the Siemens method, a polysilicon filament is required. A currently used filament is manufactured using the Czochralski (CZ) process or a floating zone (FZ) method or a manufactured polysilicon rod is processed and used according to the filament standard.

In the case of the CZ method or FZ method of manufacturing a filament by melting polysilicon, in order to form a long filament, a reactor with a length equal to or greater than the filament is required and the possibility that a filament is damaged is high due to the characteristics of a filament shape during manufacture thereof.

In particular, when a filament is processed and used directly from a polysilicon rod, it is difficult to prepare a polysilicon rod with a length equal to or greater than a length of a filament.

In addition, the possibility that a slim and long filament breaks upon being installed in a reactor is very high and, in this case, there is a limit in that reuse of the breaking filament is not possible in reality.

As a cited reference, Korean Patent Application Publication No. 10-2013-0019568 (published on February 27, 2013) discloses a "Method and apparatus for preparing polysilicon."

US2011/220283 discloses an apparatus for manufacturing a long silicon rod by welding two silicon rods together. Heating is accomplished with induction heating.

### [Disclosure]

### [Technical Problem]

It is an object of the present disclosure to provide a device for bonding polysilicon fragments to form a polysilicon filament.

It is another object of the present disclosure to provide a polysilicon filament bonding device for bonding polysilicon fragments without use of impurities.

### [Technical Solution]

In accordance with one aspect of the present disclosure, a polysilicon filament bonding device includes a body portion formed like a cylinder, a guide portion disposed in the body portion and configured to guide polysilicon fragments brought into the body portion, and a main light source for heating a bonding surface of the polysilicon fragments.

The polysilicon filament bonding device may further include auxiliary light sources for preliminarily heating a polysilicon fragment accommodated in the body portion.

The auxiliary light sources may be arranged so as not to interfere with the guide portion.

When the body portion includes a reflective surface disposed on an internal surface thereof, a heating effect using auxiliary light sources may be further enhanced.

The polysilicon filament bonding device may further include a light concentrator for concentrating light emitted from the main light source to a bonding surface.

The body portion may include a sight glass for observing a bonding surface of the polysilicon filament and may further include a fixer for fixing the polysilicon fragment.

The guide portion may be formed of a polysilicon material.

The guide portion may include a frame and a plurality of rollers rotatably connected to the frame and portions of the guide portion may be arranged in the form of a square so as to uniformly support an outer circumferential surface of the polysilicon filament.

The guide portion may be detachably formed on the body portion and may be replaceable according to a diameter of the polysilicon fragment.

The polysilicon filament bonding device may further include a guide bar formed to be inserted into the body portion to a predetermined depth and having an end positioned at a heated region of the main heat source upon being inserted into the body portion.

### [Advantageous Effects]

The present disclosure provides a device for forming a polysilicon filament by bonding a polysilicon fragment without impurities so as to reduce manufacturing costs of the polysilicon fragment.

### [Description of Drawings]

FIG. 1 is a diagram illustrating a concept of a polysilicon filament bonding device using a polysilicon fragment according to an exemplary embodiment of the present disclosure.
FIG. 2 is a perspective view of a polysilicon filament bonding device using a polysilicon fragment according to an exemplary embodiment of the present disclosure.
FIG. 3 is a cross-sectional view of a polysilicon filament bonding device using a polysilicon fragment according to another exemplary embodiment of the present disclosure.
FIG. 4 is a plan view of a polysilicon filament bonding device using a polysilicon fragment according to another exemplary embodiment of the present disclosure.
FIG. 5 is a cross-sectional view of a guide bar of a polysilicon filament bonding device using a polysilicon fragment according to an exemplary embodiment of the present disclosure.

### * Explanation of Reference numerals designating the Major Elements of the Drawings *

100: polysilicon filament bonding device
110: body portion
120: guide portion
130: main light source
140: auxiliary light source
150: fixer
160: guide bar

### [Best Mode]

Terms or words used herein shall not be limited to having common or dictionary meanings, and have the meanings corresponding to technical aspects of the embodiments of the present disclosure so as to most suitably express the embodiments of the present disclosure. In addition, embodiments described in the specification and configurations illustrated in the drawings are merely an exemplary embodiment of the present disclosure and are not limited thereto and, thus, it will be understood by those of ordinary skill in the art that various changes and equivalents in form and details may be made therein at the filing time of the application.

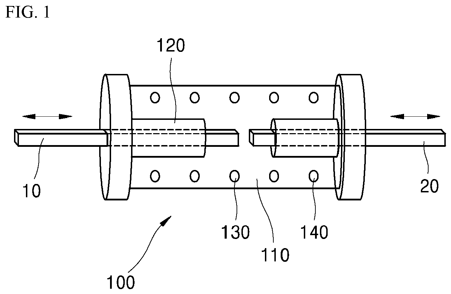

FIG. 1 is a diagram illustrating a concept of a polysilicon filament bonding device using a polysilicon fragment according to an exemplary embodiment of the present disclosure.

The polysilicon filament bonding device according to the present disclosure may be a device for bonding polysilicon fragments 10 and 20 to form a polysilicon filament with a desired length.

The polysilicon filament bonding device according to the present disclosure may melt and bond the two fragments 10 and 20 in the polysilicon filament bonding device 100 without impurities such as separate adhesives.

As illustrated in the drawing, the polysilicon filament bonding device 100 according to the present disclosure may include a cylindrical body portion 110, a guide portion 120 for guiding a polysilicon fragment that is formed and moved into the body portion, and light sources 130 and 140 for heating and welding the polysilicon fragment moved into the body portion.

The light sources may include a main light source 130 for heating a bonding surface to a polysilicon melting temperature or more and an auxiliary light source 140 for heating polysilicon around the bonding surface to the polysilicon melting temperature or less.

The guide portion 120 may be formed of a polysilicon material in order to prevent the bonded polysilicon filaments from being contaminated.

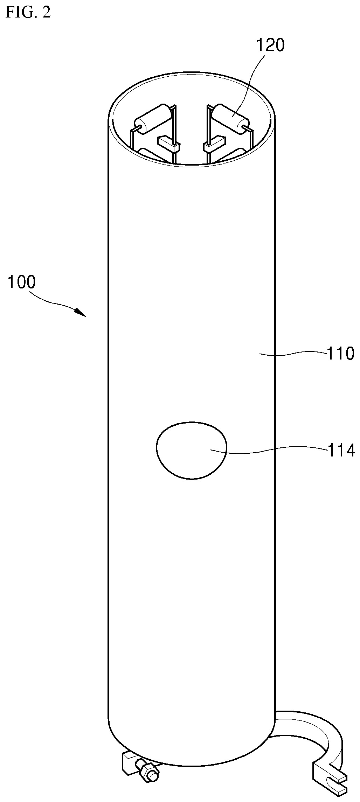

FIG. 2 is a perspective view of a polysilicon filament bonding device using a polysilicon fragment according to an exemplary embodiment of the present disclosure.

As illustrated in the drawings, the polysilicon filament bonding device 100 according to the present disclosure may include the cylindrical body portion 110, the guide portion 120 for guiding a polysilicon fragment that is formed and moved into the body portion, and the main light source 130 for heating a bonding surface of the polysilicon fragment moved into the body portion.

Although the drawings illustrate the case in which the polysilicon filament bonding device 100 is vertically positioned for convenience of illustration, the polysilicon filament bonding device 100 may be horizontally positioned and used as illustrated in FIG. 1.

A melting temperature of polysilicon is about 1414°C and, in this regard, when a halogen lamp is used as a light source and a light concentrator 132 such as a concave mirror or a convex lens is used, a portion to which light is radiated may be directly heated by the light source at a temperature equal to or greater than 1414°C.

Two polysilicon fragments may be bonded to each other by processing bonding surfaces of the polysilicon fragments to be bonded so as to have corresponding shapes, inserting one of the polysilicon fragments so as to position a bonding surface at a heating portion of the main light source 130, fixing the inserted polysilicon fragment using a fixer 150, melting the bonding surface by a main light source and, then, inserting the polysilicon fragments to be bonded.

As illustrated in the drawing, the fixer 150 may be formed in the form of a clamp and may be detachably formed so as to correspond to a diameter of the polysilicon fragment. Alternatively, a separate adaptor may be detachably formed at a clamp and may be replaced according to a diameter or cross section of polysilicon to be fixed.

A polysilicon fragment used to manufacture a polysilicon filament has a circular or square cross section and, thus, it is important to bond polysilicon fragments in a straight line. The guide portion 120 may arrange the polysilicon fragments in a straight line.

To this end, portions of the guide portion 120 may be arranged in the form of a square.

The guide portion 120 may include a frame 122 and a plurality of rollers 124 and the frame 122 may be detachably fixed to a holder portion 112 formed in the body portion 110.

The frame 122 may be fixed to the holder portion 112 via sliding fitting or tight fitting.

This may be performed in order to replace the guide portion 120 so as to correspond to a diameter of a polysilicon fragment to be bonded.

The body portion 110 may include a sight glass 114 for observing a heated region of the main light source 130 therethrough. Through the sight glass 114, the bonding surface may be checked to be appropriately positioned in the heated region of the main light source 130 and a melting state of the bonding surface may be checked.

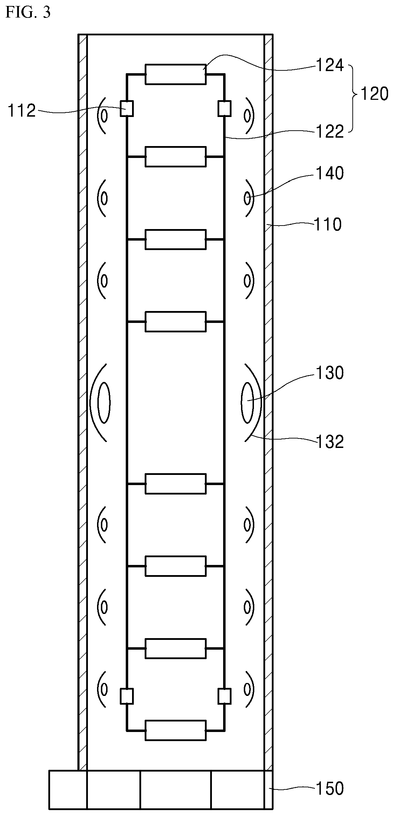

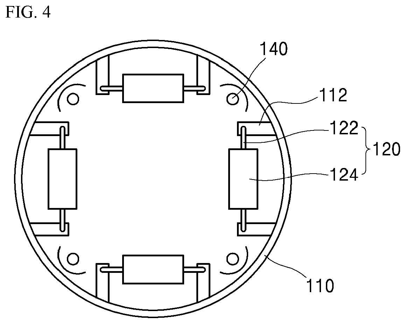

FIG. 3 is a cross-sectional view of a polysilicon filament bonding device using a polysilicon fragment according to another exemplary embodiment of the present disclosure. FIG. 4 is a plan view of a polysilicon filament bonding device using a polysilicon fragment according to another exemplary embodiment of the present disclosure.

According to the exemplary embodiment of FIGS. 3 and 4, the polysilicon filament bonding device may further include the auxiliary light source 140 for heating a polysilicon fragment accommodated in the body portion 110.

When only a bonding surface is heated to high temperature using the main light source 130, a polysilicon fragment may be damaged by thermal shock due to a local temperature difference and, thus, the polysilicon filament bonding device may further include the auxiliary light source 140 in order to heat the polysilicon fragment accommodated in the body portion 110 to an appropriate temperature.

As illustrated in FIG. 3, the auxiliary light source 140 may be disposed between the portions of the guide portion 120 and a heating temperature at which the auxiliary light source 140 is used may be in the range of 800 to 900°C. When a temperate of the auxiliary light source 140 is lower than the temperature range, the possibility that the polysilicon fragment is damaged by thermal shock due to a still high temperature difference from a bonding surface by a main light source may be increased and, when the temperature of the auxiliary light source 140 is higher than the temperature range, unnecessary energy costs may be increased.

A halogen lamp may be used as the auxiliary light source 140 like the main light source 130 and, in order to enhance a heating effect using an auxiliary light source, a reflective surface (not shown) may be disposed on an internal surface of the body portion 110. The reflective surface may reflect light emitted from the auxiliary light source 140 so as to enhance a heating effect.

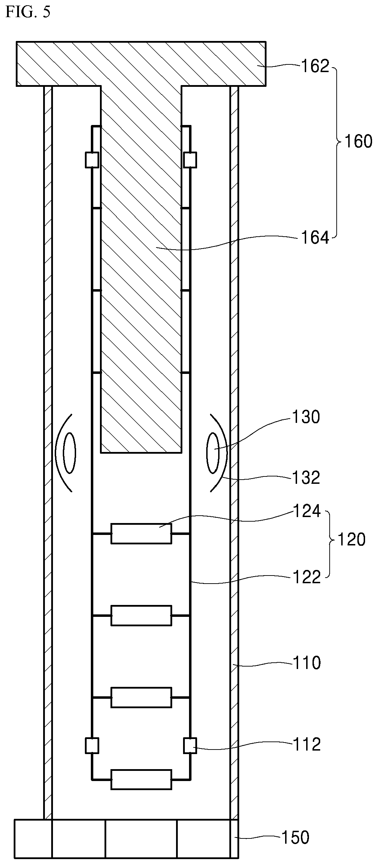

FIG. 5 is a cross-sectional view of a guide bar of a polysilicon filament bonding device using a polysilicon fragment according to an exemplary embodiment of the present disclosure.

The polysilicon filament bonding device according to the present disclosure may further include a guide bar 160. The guide bar 160 may be used to normally position a bonding surface of a polysilicon filament.

The guide bar 160 may include a head portion 162 and an insert rod 164. The head portion 162 may have a diameter with which the head portion 162 is not capable of being inserted into the body portion 110 and the insert rod 164 may have a diameter with which the insert rod 164 is capable of being inserted into the body portion 110. The insert rod 164 may have a length such that a lower end there is positioned at a central portion of a heated region of a main light source upon being completely inserted into the body portion 110.

As illustrated in the drawing, the guide bar 160 may be inserted into the body portion 110 and a polysilicon fragment may be inserted through a lower portion of the body portion 110 such that the guide bar 160 comes into contact with the insert rod of the bonding surface of the polysilicon fragment and, then, the polysilicon fragment may be fixed by the fixer 150 and the bonding surface may be fixedly positioned at the central portion of the heated region of the main light source 130.

Then, the bonding surface may be heated by the main light source 130 and the polysilicon fragment to be bonded may be inserted through an upper portion of the body portion so as to bond polysilicon fragments.

As described above, the polysilicon filament bonding device according to the present disclosure may melt and bond a plurality of polysilicon fragments without use of separate adhesives so as to manufacture a polysilicon filament with a desired length.

Accordingly, when the polysilicon filament bonding device according to the present disclosure is used, damaged polysilicon filament fragments may be reused and polysilicon filament fragments with a short length may be manufactured and bonded, thereby reducing manufacturing costs of the polysilicon filament.

## Claims

1. A polysilicon filament bonding device comprising:
a body portion formed like a cylinder;
a guide portion disposed in the body portion and configured to guide polysilicon fragments brought into the body portion; and
a main light source for heating a bonding surface of the polysilicon fragments; and a plurality of auxiliary light sources for preliminarily heating a polysilicon fragment accommodated in the body portion, wherein the auxiliary light sources are distributed along the longitudinal extension of the body portion and along the length of the polysilicon fragments contained in the body portion.

2. The polysilicon filament bonding device according to claim 1, wherein the auxiliary light sources are arranged so as not to interfere with the guide portion.

3. The polysilicon filament bonding device according to claim 2, wherein the body portion comprises a reflective surface disposed on an internal surface thereof.

4. The polysilicon filament bonding device according to claim 1, further comprising a light concentrator for concentrating light emitted from the main light source to a bonding surface.

5. The polysilicon filament bonding device according to claim 1, wherein the body portion comprises a sight glass for observing a bonding surface of the polysilicon filament.

6. The polysilicon filament bonding device according to claim 1, wherein the body portion further comprises a fixer for fixing the polysilicon fragment.

7. The polysilicon filament bonding device according to claim 1, wherein the guide portion is formed of a polysilicon material.

8. The polysilicon filament bonding device according to claim 1, wherein the guide portion comprises a frame and a plurality of rollers rotatably connected to the frame.

9. The polysilicon filament bonding device according to claim 8, wherein portions of the guide portion are arranged in the form of a square so as to uniformly support an outer circumferential surface of the polysilicon filament.

10. The polysilicon filament bonding device according to claim 1, wherein the guide portion is detachably formed on the body portion and is replaceable according to a diameter of the polysilicon fragment.

11. The polysilicon filament bonding device according to claim 1, further comprising a guide bar formed to be inserted into the body portion to a predetermined depth and having an end positioned at a heated region of the main heat source upon being inserted into the body portion.

## Patentansprüche

1. Vorrichtung zum Verbinden von Polysiliciumfragmenten, aufweisend:
einen Körperabschnitt, der wie ein Zylinder gebildet ist;
einen Führungsabschnitt, der in dem Körperabschnitt angeordnet und ausgestaltet ist, um Polysiliciumfragmente, die in den Körperabschnitt eingebracht werden, zu führen; und
eine Hauptlichtquelle zum Erhitzen einer Bindungsfläche der Polysiliciumfragmente; und mehrere Hilfslichtquellen zum einleitenden Erhitzen eines Polysiliciumfragmentes, das in dem Körperabschnitt untergebracht ist, wobei die Hilfslichtquellen längs der Längsausdehnung des Körperabschnitts und längs der Länge der Polysiliciumfragmente, die in dem Körperabschnitt enthalten sind, verteilt sind.

2. Vorrichtung zum Verbinden von Polysiliciumfragmenten nach Anspruch 1, wobei die Hilfslichtquellen angeordnet sind, um nicht störend auf den Führungsabschnitt einzuwirken.

3. Vorrichtung zum Verbinden von Polysiliciumfragmenten nach Anspruch 2, wobei der Körperabschnitt eine reflektierende Fläche aufweist, die auf einer Innenfläche davon angeordnet ist.

4. Vorrichtung zum Verbinden von Polysiliciumfragmenten nach Anspruch 1, ferner aufweisend einen Lichtkonzentrator zum Konzentrieren von Licht, das von der Hauptlichtquelle zu einer Bindungsfläche emittiert wird.

5. Vorrichtung zum Verbinden von Polysiliciumfragmenten nach Anspruch 1, wobei der Körperabschnitt ein Sichtfenster zum Beobachten einer Bindungsfläche des Polysiliciumfragmentes aufweist.

6. Vorrichtung zum Verbinden von Polysiliciumfragmenten nach Anspruch 1, wobei der Körperabschnitt ferner ein Fixiermittel zum Fixieren des Polysiliciumfragmentes aufweist.

7. Vorrichtung zum Verbinden von Polysiliciumfragmenten nach Anspruch 1, wobei der Führungsabschnitt aus einem Polysiliciummaterial gebildet ist.

8. Vorrichtung zum Verbinden von Polysiliciumfragmenten nach Anspruch 1, wobei der Führungsabschnitt einen Rahmen und mehrere Walzen aufweist, die drehbar mit dem Rahmen verbunden sind.

9. Vorrichtung zum Verbinden von Polysiliciumfragmenten nach Anspruch 8, wobei Abschnitte des Führungsabschnitts in der Form eines Quadrats angeordnet sind, um eine Außenumfangsfläche des Polysiliciumfilamentes gleichmäßig zu stützen.

10. Vorrichtung zum Verbinden von Polysiliciumfragmenten nach Anspruch 1, wobei der Führungsabschnitt abnehmbar auf dem Körperabschnitt gebildet ist und entsprechend einem Durchmesser des Polysiliciumfragmentes auswechselbar ist.

11. Vorrichtung zum Verbinden von Polysiliciumfragmenten nach Anspruch 1, ferner aufweisend einen Führungsstab, der gebildet ist, um zu einer vorbestimmten Tiefe in den Körperabschnitt eingeführt zu werden, und ein Ende aufweist, das nach dem Einführen in den Körperabschnitt an einem erhitzten Bereich der Hautwärmequelle platziert ist.

## Revendications

1. Dispositif de liaison d'un filament en polysilicium comprenant :
une partie de corps formée telle un cylindre ;
une partie de guidage disposée dans la partie de corps et conçue pour guider des fragments en polysilicium amenés dans la partie de corps ; et
une source principale de lumière permettant de chauffer une surface de liaison des fragments en polysilicium ; et une pluralité de sources auxiliaires de lumière permettant de chauffer de manière préliminaire un fragment en polysilicium logeant dans la partie de corps, dans lequel les sources auxiliaires de lumière sont distribuées le long de l'extension longitudinale de la partie de corps et le long de la longueur des fragments en polysilicium contenus dans la partie de corps.

2. Dispositif de liaison d'un filament en polysilicium selon la revendication 1, dans lequel les sources auxiliaires de lumière sont agencées de façon à ne pas interférer avec la partie de guidage.

3. Dispositif de liaison d'un filament en polysilicium selon la revendication 2, dans lequel la partie de corps comprend une surface réfléchissante disposée sur une surface interne de celle-ci.

4. Dispositif de liaison d'un filament en polysilicium selon la revendication 1, comprenant en outre un concentrateur de lumière permettant de concentrer de la lumière émise provenant de la source principale de lumière sur une surface de liaison.

5. Dispositif de liaison d'un filament en polysilicium selon la revendication 1, dans lequel la partie de corps comprend un voyant permettant d'observer une surface de liaison du filament en polysilicium.

6. Dispositif de liaison d'un filament en polysilicium selon la revendication 1, dans lequel la partie de corps comprend en outre un dispositif de fixation permettant de fixer le fragment en polysilicium.

7. Dispositif de liaison d'un filament en polysilicium selon la revendication 1, dans lequel la partie de guidage est formée d'un matériau en polysilicium.

8. Dispositif de liaison d'un filament en polysilicium selon la revendication 1, dans lequel la partie de guidage comprend un cadre et une pluralité de rouleaux reliés de manière rotative au cadre.

9. Dispositif de liaison d'un filament en polysilicium selon la revendication 8, dans lequel des portions de la partie de guidage sont agencées sous la forme d'un carré de façon à soutenir de manière uniforme une surface circonférentielle externe du filament en polysilicium.

10. Dispositif de liaison d'un filament en polysilicium selon la revendication 1, dans lequel la partie de guidage est formée de manière détachable sur la partie de corps et peut être remplacée conformément à un diamètre du fragment en polysilicium.

11. Dispositif de liaison d'un filament en polysilicium selon la revendication 1, comprenant en outre une barre de guidage formée pour être insérée dans la partie de corps à une profondeur prédéterminée et ayant une extrémité positionnée au niveau d'une région chauffée de la source principale de chaleur lorsqu'elle est insérée dans la partie de corps.
